Europäisches Patentamt

European Patent Office

Office européen des brevets

(11) Numéro de publication: **0 041 415**
**B1**

(12) **FASCICULE DE BREVET EUROPEEN**

(45) Date de publication du fascicule du brevet: **12.09.84**

(51) Int. Cl.³: **H 03 K 19/094, H 03 K 19/017**

(21) Numéro de dépôt: **81400687.0**

(22) Date de dépôt: **30.04.81**

(54) **Opérateur logique rapide, à grande entrance, à fonction logique complexe, utilisant au moins deux transistors à effet de champ à faible tension de seuil.**

(30) Priorité: **23.05.80 FR 8011550**

(43) Date de publication de la demande:
**09.12.81 Bulletin 81/49**

(45) Mention de la délivrance du brevet:
**12.09.84 Bulletin 84/37**

(84) Etats contractants désignés:
**DE GB NL**

(56) Documents cités:
**FR-A-2 264 434**

**IEEE INTERNATIONAL SOLID STATE CIRCUITS CONFERENCE, février 1980, New York, US, EDEN et al.: "Multi-level logic gate implementation in GaAs ICs using Schottky diode-FET logic", pages 122-123 et 265-266**
**IEEE SPECTRUM, vol. 14, no. 3, mars 1977, New York, US, VAN TUYL et al.: "Gallium arsenide spawns speed", pages 41-47**

(73) Titulaire: **THOMSON-CSF**
**173, Boulevard Haussmann**
**F-75379 Paris Cedex 08 (FR)**

(72) Inventeur: **Nuzillat, Gérard**
**THOMSON-CSF SCPI 173, bld Haussmann**
**F-75360 Paris Cedex 08 (FR)**
Inventeur: **Bert, Georges**
**THOMSON-CSF SCPI 173, bld Haussmann**
**F-75360 Paris Cedex 08 (FR)**

(74) Mandataire: **Taboureau, James et al**
**THOMSON-CSF SCPI 173, Bld Haussmann**
**F-75379 Paris Cedex 08 (FR)**

(56) Documents cjtés:
**IEEE TRANSACTIONS ON ELECTRON DEVICES, vol. ED-27, no. 6, juin 1980, New York, US, NUZILLAT et al.: "Quasi-Normally-Off MESFET Logic for High-Performance GaAs IC's", pages 1102-1109**
**ELECTRONIQUE INDUSTRIELLE, no. 8, 15 janvier 1981, Paris, FR, DELLA MUSSIA: "1981, l'an 1 des circuits intégrés sur arséniure de gallium", pages 27-3**

## Description

L'invention concerne la réalisation, en circuit intégré, d'opérateurs logiques, dérivés d'inverseurs logiques utilisant des transistors à effet de champ à faible tension de seuil, notamment d'opérateurs réalisant jusqu'à trois niveaux logiques par porte et possédant une entrance élevée.

On sait que, dans une porte logique complexe, on distingue autant de niveaux ou couches logiques qu'il y a d'opérateurs élémentaires sur le trajet des signaux logiques. Lorsque les opérateurs élémentaires sont des composants actifs tels que les diodes et des transistors, le signal logique subit un retard à la traversée de chaque opérateur. Il est donc intéressant, pour améliorer la rapidité du circuit logique, de réduire le nombre de couches logiques. En outre l'invention vise à améliorer l'entrance, c'est à dire à rendre l'opérateur susceptible d'être commandé simultanément par un grand nombre d'entrées dans diminution de la sécurité de fonctionnement, même en présence de bruit.

On connait de façon classique les transistors à effet de champ dites normalement conducteurs ("normally on" en anglais) et les transistors normalement bloqués ("normally off" en anglais). Les premiers sont bloqués par déplétion, necéssitant une alimentation à double polarité et présentant en outre l'inconvénient d'une consommation de courant électrique à l'état de repos. Les seconds laissent passer le courant quand on applique une tension appropriée à la grille de commande: ils ne nécessitent pas une alimentation à double polarité et sont plus économiques, mais par contre difficiles à réaliser, à cause de la très faible épaisseur du canal de conduction en donnant lieu à un grand nombre de déchets de fabrication.

Une troisième catégorie de transistors à effet de champ, qui est intermédiaire entre les deux précédentes tout en se rapprochant de la deuxième, est constituée par les transistors quasi-normalement bloqués: ils sont bloqués pour une tension de seuil $V_T$ qui peut être positive ou négative, ce qui signifie que l'on admet une certaine dispersion dans la fabrication collective de ces transistors qui est par exemple la suivante:

$$-0,4 \leq V_T \leq 0,2 \text{ volt.}$$

Cette dernière catégorie est plus facile à fabriquer que la deuxième, mais plus difficile à utiliser. On sait réaliser notamment par la technique exposée dans le document EP—A—21 858, appartenant à la demanderesse et publie le 7.01.81, des transistors à faible tension de seuil et un inverseur logique d'utilisation. Dans cette technique, on creuse, par érosion ionique, une tranchée entre la source et le drain, ce qui constitue une résistance saturable à très faible consommation, que l'on peut transformer en transistor à effet de champ en déposant une métallisation dans le fond de la tranchée à l'emplacement de la grille de commande et pour en remplir la ·fonction. Toutefois, les transistors réalisés par cette technologiqe présentent une certaine dispersion et donc, certains inconvénients, en raison de la dispersion des caractéristiques, la tension de seuil est tantôt positive, tantôt, négative; dans le cas où elle est négative, le transistor d'entrée n'est pas bloque, ce qui présente, une diminution d'entrance, interdisant notamment la constitution d'entrées multiples.

Des circuits logiques à transistors à effet de champ ont déjà été proposés, par exemple par le brevet français No. 2 264 434 de la Demanderesse, ou par RC Eden dans IEEE-ISSCC de février 1980. Dans les deux cas, les transistors utilisés sont de type à déplétion, c'est-à-dire normalement conducteurs: ils consomment même au repos, et nécessitent deux tensions d'alimentations, négative et positive par rapport à la masse, ce qui complique beaucoup l'intégration à grande échelle. De plus, dans le brevet cité, les transistors sont de deux types différents, à deux tensions de seuil, ce qui complique également la réalisation de circuits intégrés. Enfin, la logique à déplétion ne permet pas certaines combinaisons de portes.

Le circuit selon l'invention utilise des transistors à enrichissement, de type quasi-normalement bloqués, ne nécessitant qu'une seule tension d'alimentation par rapport à la masse. Tous les transistors du circuit ont même tension de seuil. Ils peuvent être réalisés sur silicium mais l'invention prend tout son intérêt avec des circuits intégrés sur matériaux de type III—V, GaAs par exemple.

L'opérateur logique selon l'invention est défini dans la revendication 1.

Des modes de réalisation particuliers sont définies dans les revendications dépendantes.

L'invention sera mieux comprise, et d'autres caractéristiques apparaitront, au moyen de la description qui suit, et des dessins qui l'accompagnent, parmi lesquels:

la figure 1 représente un type connu d'inverseur logique à TFS;

les figures 2 à 6 représentent des variantes classiques ou nouvelles, d'inverseurs logiques utilisant au moins un TFS;

la figure 7 est un exemple de réalisation d'opérateur logique à 8 entrées conforme à l'invention;

la figure 8 est un schéma fonctionnel de porte logique complexe réalisée par l'opérateur de la figure précédente;

les figures 9 à 17 représentent d'autres réalisations d'opératuers logiques conformes à invention.

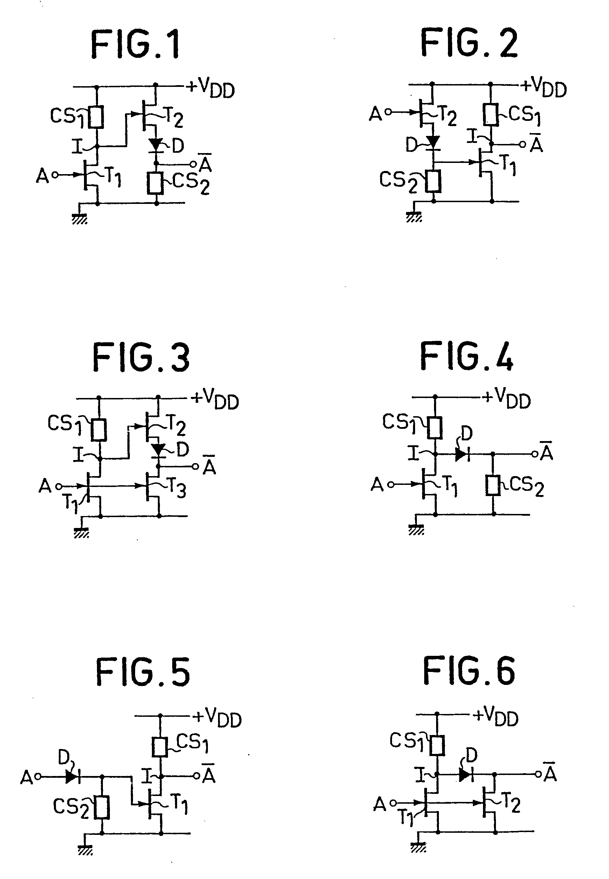

Sur la figure 1, on a représenté un inverseur logique dont l'entrée A est connectée à la grille d'un transistor $T_1$ qui est un TFS. Ce transistor a sa source à la masse, son drain connecté au point I connecté lui-même au point chaud correspondant à un pôle (positif dans cet exemple) d'une source $V_{DD}$ à travers une charge résistive $CS_1$. L'exemple choisi correspond au cas du transistor à canal n. Pour un canal p les polarités doivent être inversées.

Le point I est connecté à la grille d'un transistor $T_2$ qui est un TFS. Le transistor $T_2$ a son drain connecté au pôle $+V_{DD}$, sa source à une diode D, passante dans le sens allant de $+V_{DD}$ à la masse. Le retour à la masse s'effectue à travers une charge résistive $CS_2$ du même type que $CS_1$. La sortie A de l'inverseur est prise entre D et $CS_2$.

On rappelle brièvement les règles de fonctionnement de l'inverseur. Lorsque l'entrée A est à l'état "0" (potentiel nul ou légèrement positif) le transistor $T_1$ est bloqué ou quasi-bloqué. Le potentiel au point I est voisin de celui du pôle $+V_{DD}$. La jonction grille-source de transistor $T_2$ étant polarisée en direct, le potentiel de la source tend à monter, de même que la sortie $\overline{A}$, mais avec un décalage de tension dû à la diode. On a l'état "1" de la sortie, dont le potentiel est positif grâce à la présence de la charge résistive $CS_2$.

Lorsque l'entrée A est à l'état "1" (par exemple au voisinage de 0,8 volt), le potentiel du point I est bas, de l'ordre de la tension de déchet du transistor $T_1$, et le transistor $T_2$ est par conséquent bloqué par sa grille. On montre que, trâce à la présence de la diode D, le potentiel de la sortie $\overline{A}$ est voisin de la masse (état "0").

On montre facilement que le fonctionnement de l'inverseur est correct si la tension de seul est comprise entre les limites:

$$-0,4\ V \le V_T \le +0,2\ V$$

On montre également que, si l'on ajoute une entrée en utilisant un transistor $T_1$ à deux grilles, réalisant ainsi une porte du type "ET NON" à deux entrées, le fonctionnement reste satisfaisant, et présente une certaine marge de bon fonctionnement malgré le bruit inévitable dans le signal d'entrée.

Une bonne appréciation de cette marge est fournie en évaluant le rapport du courant résiduel $I_{res}$, à l'état "0" dans le cas défavorable où $V_T=-0,4\ V$, au courant maximum $I_{max}$, à l'état "1".

Or, en raison de la caractéristique quadratique "tension/courant" des transistors à effet de champ, on a la relation suivante:

$$\frac{I_{res}}{I_{max}} = \left(\frac{V_T}{V_p}\right)^2 \qquad (1)$$

où $V_T$ est la tension de seuil du TFS et $V_p$ la tension grille-source maximale diminuée de la tension de seuil.

Dans le cas d'une seule entrée, on à, si $V_p=0,8+0,4=1,2$ volt:

$$\frac{I_{res}}{I_{max}} = \frac{1}{9} \qquad (2)$$

Dans le cas de n entrées, on a:

$$\frac{I_{res}}{I_{max}} = \frac{n}{9} \qquad (3)$$

On voit qu'à partir de trois entrées, le rapport est de 1/3, soit 33%. On estime la marge insuffisante dans ce cas, ce qui conduit à limiter à deux le nombre d'entrées sur un même transistor.

On verrait facilement que les variantes de l'inverseur de la figure 1 représentées sur les figures 2 à 6, ont un fonctionnement et des limitations analogues en ce qui concerne le nombre d'entrées.

L'inverseur de la figure 2 est un opérateur utilisant le circuit de la figure 1 après inversion de la branche d'entrée et de la branche de sortie. En outre, tout se passe comme si dans cette inversion on avait coupé la liaison "point I — grille $T_2$" pour établir la nouvelle entrée A sur la grille $T_2$ et la nouvelle sortie $\overline{A}$ sur le point I. On montrerait facilement que les potentiels sont les mêmes que dans le cas de l'inverseur de la figure 1, lorsqu'on passe de l'état "0" à l'état "1" en réciproquement tant en entrée qu'en sortie.

L'inverseur de la figure 3 est un opérateur utilisant un circuit analogue à celui de la figure 1, dans lequel la charge résistive $CS_2$ est remplacée par un transistor $T_3$ qui est un TFS identique à $T_1$ dont la grille est connectée directement à l'entrée A, comme la grille de $T_1$, ce qui permet un gain de rapidité.

L'inverseur de la figure 4 est un opérateur utilisant un circuit qui se différencie de celui de la figure 1 par la suppression du transistor $T_2$ et la connexion directe du drain de $T_1$ avec la diode D.

L'inverseur de la figure 5 est un opérateur utilisant le circuit de la figure 4 en inversant la branche d'entrée et la branche de sortie. Tout se passe comme si dans cette inversion on avait coupé la liaison entre le point I et la diode D, pour établir la nouvelle entrée sur la diode et la nouvelle sortie au point I.

L'inverseur de la figure 6 est un opérateur utilisant le circuit de la figure 4 en remplaçant la charge $CS_2$ par un TFS dont la grille est connectée directement à l'entrée A, comme la grille de $T_1$, ce qui permet un gain de rapidité.

Premier Exemple
On donne ci-après un premier exemple de réalisation de l'invention.

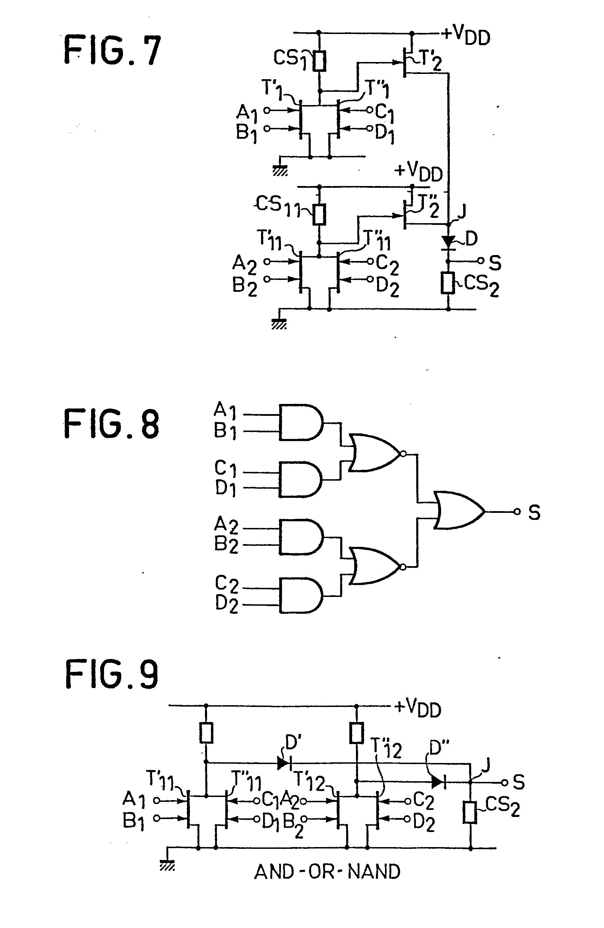

On a constitué (figure 7) un opérateur logique à huit entrées, dérivé d'un inverseur de la figure 1, remplissant la fonction:

"ET—OU NON—OU" (AND—NOR—OR)
(Figure 8) ou

"ET—OU—ET NON" (AND—OR—NAND).

Le schéma de cet opérateur comporte des branches et des demi-branches articulées de façon analogue à celle de la figure 1, mais avec des mises en parallèle de grilles de transistors, de transistors eux-mêmes et de portions de circuits composées de trois demi-branches.

On a procédé de la façon suivante:

1°) Dans une première portion de circuit, deux transistors TFS, soit $T'_1$ et $T''_1$, à deux grilles ($A_1$, $B_1$ pour $T'_A$) ($C_1$ et $D_1$ pour $T''_1$) sont montés en parallèle dans une demi-branche d'entrée. On complète ensuite la portion de circuit par une demi-branche d'entrée du type à charge résistive ($CS_1$) et par une demi-branche de sortie contenant un transistor $T'_2$;

2°) Dans une deuxième portion de circuit, deux autres transistors $T'_{11}$ et $T''_{11}$ à deux grilles chacun ($A_2$, $B_2$, $C_2$ et $D_2$) sont montés de façon analogue; on complète ensuite la deuxième portion de circuit de façon analogue à la première par une charge résistive $CS_{11}$ et un transistor $T''_2$.

3°) Les transistors $T'_2$ et $T''_2$ de ces demi-branches sont alors mis en parallèle par un point commun J sur une demi-branche de sortie à diode D et à charge résistive $CS_2$ du type de celle de la figure 1, la borne de sortie S étant prise entre la diode D et la charge $CS_2$.

Les fonctions logiques de l'opérateur ainsi obtenu se déduisent facilement du fait que les mises en parallèles successives, prises une par une produiraient si elles étaient seules, l'équivalent d'une fonction OU dans le cas de deux transistors et d'une fonction ET dans le cas de deux grilles d'entrée d'un transistor "quasi-normalement bloqué", compte-tenu en outre de l'inversion (porte NON) inhérente au circuit de base.

On constate expérimentalement que, malgré l'augmentation du nombre de fonctions et d'entrées de l'opérateur, la marge de fonctionnement en présence de bruit est du même ordre que celle d'un simple inverseur du type de la figure 1 n'ayant qu'un seul transistor d'entrée à deux grilles.

Une explication possible semble découler de constations d'ordre statistiques effectuées lors de la réalisation de plusieurs transistors de mêmes caractéristiques géométriques occupant une petite région d'une même plaquette ce cristal semiconducteur. En effet, les caractéristiques électriques de tels transistors sont en général extrêmement voisines. C'est donc le cas de la caractéristique constituée par la tension de seuil $V_T$ des TFS, dont le rôle joue en rôle déterminant dans la marge de fonctionnement.

Il découle de ces constatations qu'un opérateur constitué de TFS très voisins sur la plaquette ne comportera en moyenne que des transistors TFS bons ou des TFS mauvais (c'est-à-dire hors normes) mais en général pas de mélange de TFS bons et mauvais. Ceci constitue un facteur statistique favorable au rendement de fabrication des circuits intégrés d'opérateurs logiques selon l'invention.

Deuxième exemple

Dans une deuxième réalisation de l'invention, (figure 9), on trouve un opérateur à 8 entrées, dérivé de l'inverseur de la figure 4, remplissant la fonction:

"ET—OU—ET NON" (AND—OR—NAND)

Cet opérateur est obtenu en mettant en parallèle deux grilles (entrées $A_1$ et $B_1$, $C_1$ et $D_1$, $A_2$ et $B_2$, $C_2$ et $D_2$) sur chacun des transistors type $T_1$ (voir figure 4) que l'on monte en paires parallèles, soit, respectivement, $T'_{11}$ et $T''_{11}$, $T'_{12}$ et $T''_{12}$. Les deux branches d'entrée et leurs diodes de liaison D' et D'' forment deux portions de circuit mises en parallèle au point J sur une charge unique $CS_2$, la sortie étant prise au point J.

On remarque que l'opérateur de ce deuxième exemple réalise les mêmes fonctions logiques que celui du premier, mais avec deux transistors en moins.

On a fait des constatations analogues à celles du premier exemple en ce que concerne la tenue au bruit et le rendement de fabrication.

Troisième exemple

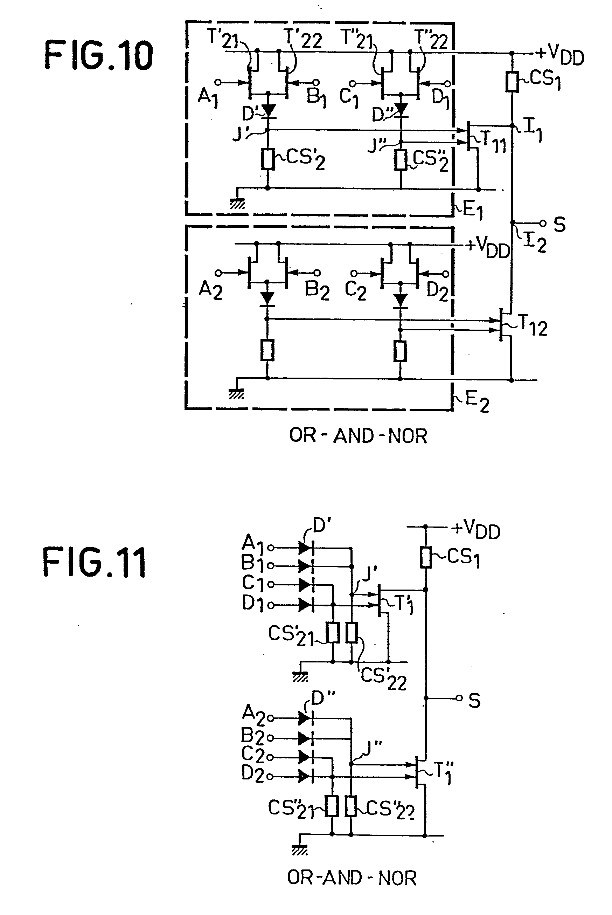

Dans un troisième exemple de réalisation de l'invention (figure 10), on trouve un opérateur à 8 entrées, dérivé d'un inverseur de la figure 2, remplissant la fonction:

OU—ET—OU NON (OR—AND—NOR)

Cet opérateur est obtenu en constituant deux portions de circuit $E_1$ et $E_2$, contenant chacune (seules les composants de $E_1$ portent des repères) de façon identique:

— deux transistors $T'_{21}$ et $T'_{22}$ du type de la figure 2, en parallèle sur une demi-branche comprenant en série une diode D' et une charge $CS'_2$;

— deux transistors $T''_{21}$ et $T''_{22}$ du type $T_2$ de la figure 2, en parallèle sur une demi-branche comprenant en série une diode D'' et une charge $CS''_2$.

Les portions de circuit $E_1$ et $E_2$ sont complétées respectivement par une demi-branche contenant un transistor de type $T_1$ de la figure 2, à savoir les transistors $T_{11}$ et $T_{12}$, possèdant chacun deux grilles respectivement reliées à des points J' et J'' de connexion entre diode (D', D'') et charge ($CS'_2$, $CS''_2$) d'une demi-branche d'entrée.

Les transistors $T_{11}$ et $T_{12}$ sont mis en parallèle en des points de connexion $I_1$ et $I_2$ reliés entre eux ainsi qu'à la sortie S de l'opérateur et à la

borne de CS$_2$ opposée à celle qui est reliée au pôle +V$_{DD}$ de l'alimentation.

### Quatrième exemple

Dans une quatrième réalisation (figure 11), on trouve un opérateur à 8 entrées, dérivé d'un inverseur du type de la figure 5, remplissant la fonction suivante:

#### OU—ET—OU NON (OR—AND—NOR)

Cet opérateur est obtenu en constituant deux groupes de quatre diodes D' et D'', respectivement reliées entre les bornes d'entrée de l'opérateur (A$_1$, B$_1$, C$_1$, D$_1$, A$_2$, B$_2$, C$_2$, D$_2$) divisées en deux groupes eux-mêmes divisés en deux paires, chaque paire étant en parallèle sur une charge de type CS$_2$ (CS'$_{21}$ et CS'$_{22}$ pour un groupe, CS''$_{21}$ et CS''$_{22}$ pour l'autre).

Si l'on désigne par J' et J'' respectivement les bornes d'entrée des charges CS'$_{21}$ et CS'$_{22}$ d'une part, et d'autre part des charges CS''$_{21}$ et CS''$_{22}$, les bornes J' (ou J'') sont reliées à deux grilles de transistors de type T$_1$ (T'$_1$ et T''$_1$) dont les drains sont connectés en parallèle à la sortie S et à la borne de la charge CS opposée au pôle +V$_{DD}$ de l'alimentation.

### Cinquième exemple

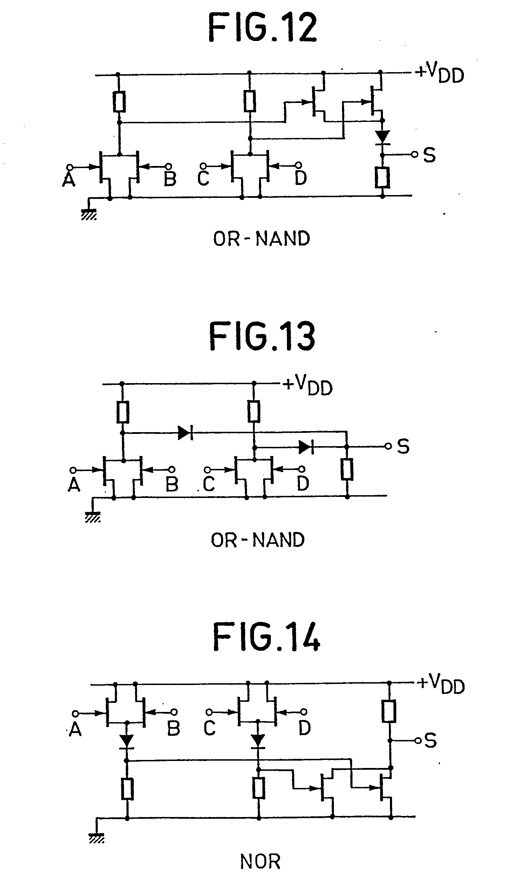

Dans une cinquième réalisation (figure 12), on trouve un opérateur à quatre entrées analogue à celui du premier exemple, dans lequel on a des transistors d'entrée à une seule grille au lieu de deux grilles ce qui réduit le nombre d'entrées, mais aussi les fonctions logiques, qui se résument alors à:

#### OU—ET NON (OR—NAND)

### Sixème, Septième et Huitième exemples

Dans ces réalisations (figures 13, 14 et 15) les opérateurs sont à quatre entrées et respectivement analogues aux opérateurs des deuxième, troisième et quatrième exemples dans lesquels on a utilisé des transistors d'entrée à une seule grille. Ils ne remplissent que les fonctions logiques suivantes:

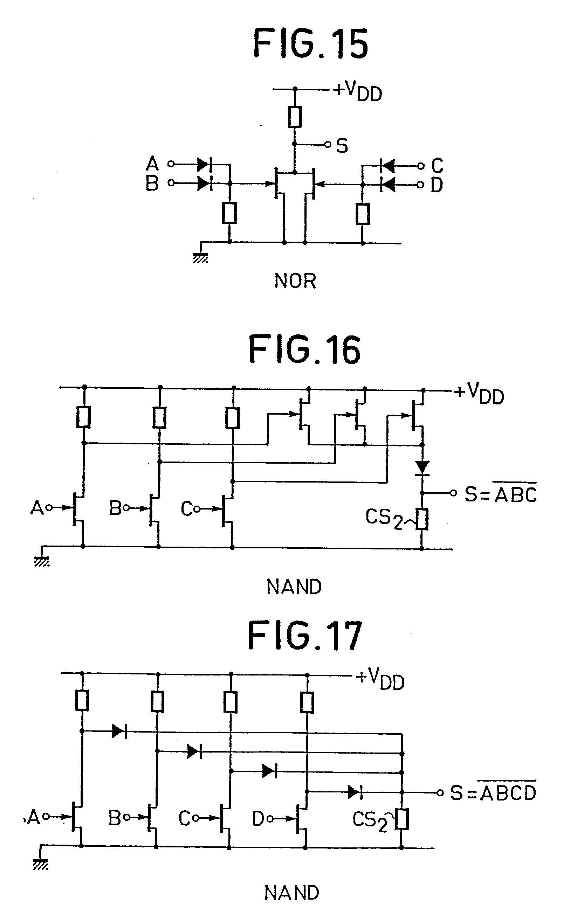

OU—ET NON (OR—NAND) dans le cas de la figure 13
OU NON (NOR) dans le cas des figures 14 et 15.

### Neuvième et Dixième exemples

Dans les réalisations des figures 16 et 17, on trouve des opérateurs à 3 et 4 entrées, dérivés respectivement de l'inverseur de la figure 1 et de celui de la figure 4, par mise en parallèle de portions de circuit comprenant l'inverseur de base dans lequel on aurait supprimé la branche de sortie comportant la charge. Cette mise en parallèle s'effectue sur la borne S reliée à la borne de CS$_2$ qui n'est pas à la masse.

La fonction logique remplie est, dans les deux cas:

#### ET NON (NAND).

## Revendications

1. Opérateur logique rapide à grande entrance fonctionnant à partir d'une seule source d'alimentation dont un premier pôle fournit une tension d'alimentation et dont l'autre pôle est relié à la masse, comportant au moins deux transistors à effet de champ quasi-normalement bloqués à faible tension de seuil, chacun desdits transistors comportant au moins une grille reliée à une entrée de l'opérateur, le signal de sortie de l'opérateur étant prélevé en aval d'un circuit OU câblé, reliant les sources ou les drains respectifs des deux transistors.

2. Opérateur logique selon la revendication 1, réalisant la fonction logique complexe de forme ET—OU—ET NON, caractérisé en ce qu'il comporte deux portions de circuit montées en parallèle sur une branche de sortie, de façon à réaliser ladite fonction OU câblé, chaque portion de circuit comprenant en série entre ledit premier pôle (+V$_{DD}$) et la masse une demi-branche d'entrée constituée par une première charge résistive (CS$_1$) reliée audit premier pôle (+V$_{DD}$), et une demi-branche d'entrée reliée à la masse constituée par la mise en parallèle de deux transistors (T'$_1$, T''$_1$) comportant chacun au plus deux grilles constituant les entrées (A$_1$, B$_1$, C$_1$, D$_1$) de l'opérateur, chaque portion de circuit comprenant en outre un transistor (T'$_2$) dont la grille est reliée au point de connexion des deux demi-branches d'entrée, dont de drain est relié audit premier pôle (+V$_{DD}$), et dont la source est reliée à la masse à travers la branche de sortie constituée par la mise en série d'une diode (D) conductrice dans le sens du premier pôle (+V$_{DD}$) vers la masse et d'une deuxième charge résistive (CS2), la sortie (S) de l'opérateur étant prise entre diode (D) et charge résistive (CS2).

3. Opérateur logique selon la revendication 1, réalisant la fonction logique complexe de forme ET—OU—ET NON, caractérisé en ce qu'il comporte deux portions de circuit montées en parallèle sur une branche de sortie de façon à réaliser ladite fonction OU câblé, chaque portion de circuit comprenant en série entre ledit premier pôle (+V$_{DD}$) et la masse une demi-branche d'entrée constituée par une première charge résistive (CS1) reliée audit premier pôle et une demi-branche d'entrée reliée à la masse, constituée par la mise en parallèle de deux transistors (T'$_{11}$, T''$_{11}$) comportant chacun au plus deux grilles constituant les entrées (A$_1$, B$_1$, C$_1$, D$_1$) de l'opérateur, chaque portion de circuit comprenant en outre une diode (D', D'') conductrice du point de connexion des demi-branches d'entrée vers le point de connexion de la branche de sortie, constituée par une deuxième charge résistive (CS2) reliée à la masse.

4. Opératuer logique selon la revendication 1, réalisant la fonction logique complexe du forme OU—ET—OU NON, caractérisé en ce qu'il comporte deux portions de circuit montées en parallèle sur une branche de sortie de façon à réaliser ladite fonction OU câblé, chaque portion de circuit comprenant en série entre ledit premier pôle ($+V_{DD}$) et la masse deux branches d'entrée comprenant chacune une demi-branche d'entrée constituée par une charge résistive (CS'2) reliée à la masse, et une demi-branche d'entrée reliée audit premier pôle ($+V_{DD}$), constituée par la mise en parallèle de deux transistors ($T'_{21}$, $T'_{22}$) comportant chacun au moins une grille reliée à une entrée ($A_1$, $B_1$) de l'opérateur, l'ensemble de ces deux transistors étant en série avec une diode (D') conductrice dans le sens allant dudit premier pôle à la masse, chaque portion de circuit comprenant en outre un transistor (T11) à deux grilles respectivement reliées aux points de connexion (J'J'') entre diode et charge résistive de chaque branche d'entrée, dont la source est à la masse et dont le drain est reliée à la borne de la branche de sortie constituée par une autre charge résistive (CS1) reliée audit premier pôle ($+V_{DD}$).

5. Opérateur logique selon la revendication 1, réalisant la fonction logique complexe de forme OU—ET—OU NON, caractérisé en ce qu'il comporte deux portions de circuit montées en parallèle sur une branche de sortie de façon à réaliser ladite fonction OU câblé, chaque portion de circuit comprenant en parallèle deux branches d'entrée chacune de ces branches étant constituée respectivement par le montage en parallèle d'au moins deux diodes (D'), conductrices dans le sens vers la masse, la première borne desdites diodes constitue une entrée de l'opérateur et les autres bornes desdites diodes sont reliées à la masse à travers une charge résistive (CS'21), chaque portion de circuit comprenant en outre un transistor (T'1) à deux grilles au moins, dont la source est à la masse, chaque grille reliée au point de connextion (J') desdites autre bornes desdites diodes et la ladite résistance dans chacune des branches d'entrée respectives, et dont le drain est relié à la borne de la branche de sortie constituée par une autre charge résisitive (CS1) reliée audit premier pôle ($+V_{DD}$) de la source.

6. Opérateur logique selon la revendication 1, réalisant la fonction logique complexe de forme OU—ET NON, caractérisé en ce qu'il comporte deux portions de circuit montées en parallèle de façon à réaliser ladite fonction OU câblé, sur une branche de sortie constituée par une première charge résistive reliée à la masse, chaque portion de circuit comprenant en série entre ledit premier pôle ($+V_{DD}$) et la masse une branche d'entrée comprenant en série une demi branche d'entrée constituée par une seconde charge résistive reliée audit premier pôle, et une demi-branche d'entrée reliée à la masse et constituée par la mise en parallèle de deux transistors comportant chacun au moins une grille reliée à une entrée (A, B) de l'opérateur, chaque portion de circuit comprenant en outre une diode, conductrice dans le sens allant dudit premier pôle à la masse, montée entre le point de connexion entre demi-branches d'entrée et la première charge résistive, la sortie (S) de l'opérateur étant prise entre diode et première charge résistive.

7. Opérateur logique selon la revendication 1, réalisant la fonction logique de forme OU NON, caractérisé en ce qu'il comporte deux portions de circuit montées en parallèle de façon à réaliser ladite fonction OU câblé sur une branche de sortie constituée par une première charge résistive reliée audit premier pôle ($+V_{DD}$), chaque portion de circuit comprenant en série entre ledit premier pôle et la masse une branche d'entrée comprenant en série une demi-branche d'entrée constituée par une seconde charge résistive reliée à la masse, et une demi-branche d'entrée reliée audit premier pôle et constituée par la mise en parallèle de deux transistors comportant chacun au moins une grille reliée à une entrée (AB) de l'opérateur, en série avec une diode conductrice dans le sens du premier pôle vers la masse, chaque portion de circuit comprenant en outre un transistor dont la source est à la masse, le drain est relié à la première charge résistive et la grille est reliée au point de connexion entre demi-branches d'entrée, la sortie (S) de l'opérateur étant prise entre drain du transistor de sortie et la première charge résistive.

8. Opérateur logique selon la revendication 1, réalisant la fonction logique de forme ET NON, caractérisé en ce qu'il comporte trois portions de circuit montées en parallèle de façon à réaliser ladite fonction OU câblé sur une branche de sortie constituée par une diode en série avec une première charge résistive reliée à la masse, chaque portion de circuit comprenant respectivement entre ledit premier pôle et la masse une branche d'entrée constituée par une demi-branche d'entrée formée par une seconde charge résistive, reliée audit premier pôle, et une demi-branche d'entrée formée par un transistor dont la source est à la masse, le drain est connecté à la première demi-branche d'entrée et la grille à une entrée de l'opérateur, chaque portion de circuit comprenant en outre un autre transistor dont le drain est relié audit premier pôle, la grille reliée au point de connexion entre demi-branches d'entrée et dont la source est reliée à l'entrée de la branche de sortie, la sortie (S) de l'opérateur étant prise entre diode et première charge résistive.

9. Opérateur logique selon la revendication 1, réalisant la fonction logique de forme ET NON, caractérisé en ce qu'il comporte trois portions de circuit montées en parallèle de façon à réaliser ladite fonction OU câblé sur une branche de sortie constituée par une première charge résistive reliée à la masse, chaque portion de circuit comprenant respectivement en série entre ledit premier pôle et la masse une demi-branche d'entrée constituée par une seconde charge résistive, et une demi-branche d'entrée comprenant un transistor dont la source est à la masse, le drain relié à la borne de ladite seconde charge résistive qui est reliée audit premier pôle, et dont la grille est une entrée de l'opérateur, chaque portion de circuit comprenant en outre une diode, conductrice dans le sens allant dudit premier pôle vers la masse, dont une borne est reliée au drain du transistor, et dont l'autre borne est reliée à la première charge résistive, la sortie de l'opérateur étant prise entre diode et première charge résistive.

## Patentansprüche

1. Schneller logischer Operator mit großem Eingabevermögen und welcher mit einer einzigen Versorgungsquelle betrieben wird, deren erster Pol eine Versorgungsspannung liefert und deren zweiter Pol mit Masse verbunden ist, mit wenigstens zwei Feldeffekttransistoren, die quasi normal gesperrt sind und eine geringe Schwellspannung aufweisen, wobei jeder dieser Transistoren wenigstens ein Gate aufweist, das mit einem Eingang des Operators verbunden ist, und wobei das Ausgangssignal des Operators hinter einer verdrahteten OR-Schaltung abgenommen wird, welche die jeweiligen Source- oder Drain-Elektroden der beiden Transistoren verbindet.

2. Logischer Operator nach Anspruch 1, der eine komplexe logische Funktion der Form AND—OR—NAND verwirklicht, dadurch gekennzeichnet, daß er zwei an einem Ausgangszweig derart parallel geschaltete Schaltungsteile enthält, daß die genannte verdrahtete OR-Funktion verwirklicht wird, wobei jeder Schaltungsteil in Reihe zwischen dem ersten Pol $(+V_{DD})$ und Masse einen halben Eingangszweig, der durch eine erste, mit dem ersten Pol $(+V_{DD})$ verbundene resistive Last $(CS_1)$ gebildet ist, und einen halben Eingangszweig enthält, der mit Masse verbunden ist und durch die Parallelschaltung aus zwei Transistoren $(T'_1, T''_1)$ gebildet ist, welche jeweils höchstens zwei Gates enthalten, die die Eingänge $(A_1, B_1, C_1, D_1)$ des Operators bilden, wobei jeder Schaltungsteil ferner einen Transistor $(T'_2)$ enthält, dessen Gate mit dem Verbindungspunkt der zwei halben Eingangszweige verbunden ist, dessen Drain mit dem genannten ersten Pol $(V_{DD})$ und dessen Source mit Masse über den Ausgangszweig verbunden ist, welcher gebildet ist aus der Reihenschaltung einer Diode (D), die in Richtung des ersten Pols $(+V_{DD})$ gegen Masse leitet, und einer zweiten resistiven Last (CS2), wobei der Ausgang (S) des Operators zwischen der Diode (D) und der resistiven Last (CS2) abgegriffen ist.

3. Logischer Operator nach Anspruch 1, welcher die komplexe logische Funktion der Form AND—OR—NAND verwirklich, dadurch gekennzeichnet, daß er zwei an einem Ausgangszweig derart parallel geschaltet Schaltungsteile enthält, daß die genannte verdrahtete OR-Funktion verwirklicht wird, wobei jeder Schaltungsteil in Reihe zwischen dem ersten Pol $(+V_{DD})$ und Masse einen halben Eingangszweig, der aus einer ersten, mit dem genannten ersten Pol verbundenen resistiven Last (CS1) besteht, und einen halben Eingangszweig enthält, der mit Masse verbunden ist und gebildet ist durch die Parallelschaltung von zwei Transistoren $(T'_{11}, T''_{11})$, die jeweils höchstens zwei Gates enthalten, welche die Eingänge $(A_1, B_1, C_1, D_1)$ des Operators bilden, wobei jeder Schaltungsteil ferner eine Diode (D'D'') enthält, die von dem Verbindungspunkt der halben Eingangszweige zu dem Anschlußpunkt des Ausgangszweigs leitet, welcher durch eine zweite resistive Last (CS2) gebildet ist, die mit Masse verbunden ist.

4. Logischer Operator nach Anspruch 1, welcher die komplexe logische Funktion der Form OR—AND—NOR verwirklicht, dadurch gekennzeichnet, daß er zwei Schaltungsteile enthält, die an einem Ausgangszweig derart parallel geschaltet sind, daß die genannte verdrahtete OR-Funktion verwirklicht wird, wobei jeder Schaltungsteil in Reihe zwischen dem ersten Pol $(+V_{DD})$ und Masse zwei Eingangszweige enthält, die jeweils einen halben, aus einer mit Masse verbundenen resistiven Last $(CS'2)$ gebildeten Eingangszweig und einem mit dem ersten Pol $(+V_{DD})$ verbundenen halben Eingangszweig enthalten, welcher durch die Parallelschaltung von zwei Transistoren $(T'21, T'22)$ gebildet ist, die jeweils wenigstens ein Gate aufweisen, das mit einem Eingang $(A_1, B_1)$ des Operators verbunden ist, wobei die Gesamtheit dieser zwei Transistoren in Reihe mit einer Diode (D') liegt, die in Richtung von dem ersten Pol zur Masse leitet, wobei jeder Schaltungsteil ferner einen Transistor (T11) mit zwei Gates aufweist, die mit dem einen bzw. anderen Verbindungspunkt (J', J'') zwischen Diode und resistiver Last des betreffenden Eingangszweiges verbunden sind, dessen Source an Masse liegt und dessen Drain mit dem Anschluß des Ausgangszweiges verbunden ist, der durch eine weitere resistive Last (CS1) gebildet ist, die mit dem ersten Pol $(+V_{DD})$ verbunden ist.

5. Logischer Operator nach Anspruch 1, welcher die komplexe logische Funktion der Form OR—AND—NOR verwirklicht, dadurch gekennzeichnet, daß er zwei Schaltungsteile umfaßt, die an einem Ausgangszweig derart parallel geschaltet sind, daß die genannte verdrahtete OR-Funktion verwirklicht wird, wobei jeder Schaltungsteil zwei parallel liegende Eingangszweige aufweist, von denen jeder durch die Parallelschaltung von wenigstens zwei Dioden (D') gebildet ist, die in Richtung gegen Masse leiten, wobei der erste Anschluß dieser Dioden einen Eingang des Operators bildet und die anderen Anschlüsse dieser Dioden über eine resistive Last $(CS'21)$ mit Masse verbunden sind, wobei ferner jeder Schaltungsteil einen Transistor (T'1) mit wenigstens zwei Gates aufweist, dessen Source mit Masse verbunden ist, wobei jedes Gate mit dem Verbindungspunkt (J') der anderen Anschlüsse der Dioden und dem genannten Widerstand in dem entsprechenden Eingangszweig verbunden ist, und dessen Drain mit dem Anschluß des Ausgangszweiges verbunden ist, welcher durch eine weitere resistive Last (CS1) gebildet ist, die mit dem ersten Pol (+$V_{DD}$) der Quelle verbunden ist.

6. Logischer Operator nach Anspruch 1, welcher die komplexe logische Funktion der Form OR—NAND verwirklicht, dadurch gekennzeichnet, daß er zwei Schaltungsteile umfaßt, die derart parallel geschaltet sind, daß die genannte verdrahtete OR-Funktion verwirklicht wird, und zwar an einem Ausgangszweig, der durch eine ersten resistive, mit Masse verbundene Last gebildet ist, wobei jeder Schaltungsteil in Reihe zwischen dem ersten Pol (+$V_{DD}$) und Masse einen Eingangszweig aufweist, der in Reihenschaltung einen halben Eingangszweig, der durch eine zweite, mit dem ersten Pol verbundene resistive Last gebildet ist, und einen halben Eingangszweig aufweist, welcher mit Masse verbunden ist und durch die Parallelschaltung von zwei Transistoren gebildet ist, die jeweils wenigstens ein Gate aufweisen, das mit einem Eingang (A, B) des Operators verbunden ist, wobei jeder Schaltungsteil ferner eine Diode aufweist, die in der Richtung von dem ersten Pol nach Masse leitet und zwischen den Verbindungspunkt zwischen den halben Eingangszweigen und die erste resistive Last geschaltet ist, wobei der Ausgang (S) des Operators zwischen der Diode und der ersten resistiven Last abgegriffen ist.

7. Logischer Operator nach Anspruch 1, welcher die logische Funktion der Form NOR verwirklicht, dadurch gekennzeichnet, daß er zwei Schaltungsteile aufweist, die derart parallel geschaltet sind, daß sie die genannte verdrahtete OR-Funktion an einem Ausgangszweig verwirklichen, der aus einer ersten resistiven, mit dem ersten Pol (+$V_{DD}$) verbundenen Last gebildet ist, wobei jeder Schaltungsteil in Reihe zwischen dem ersten Pol und Masse einen Eingangszweig aufweist, der in Reihe einen halben Eingangszweig, welcher durch eine zweite, mit Masse verbundene resistive Last gebildet ist, und einen halben Eingangszweig aufweist, der mit dem ersten Pol verbunden ist und durch die Parallelschaltung von zwei Transistoren gebildet ist, die jeweils wenigstens ein Gate aufweisen, das mit einem Eingang (AB) des Operators verbunden ist, in Reihe mit einer Diode, die in Richtung von dem ersten Pol nach Masse leitet, wobei jeder Schaltungsteil ferner einen Transistor enthält, dessen Source mit Masse verbunden ist, dessen Drain mit der ersten resistiven Last verbunden ist und dessen Gate mit dem Verbindungspunkt zwischen den halben Eingangszweigen verbunden ist, während der Ausgang (S) des Operators zwischen dem Drain des Ausgangstransistors und der ersten resistiven Last abgegriffen ist.

8. Logischer Operator nach Anspruch 1, welcher die logische Funktion der Form NAND verwirklicht, dadurch gekennzeichnet, daß er drei Schaltungsteile aufweist, die derart parallel geschaltet sind, daß sie die genannte verdrahtete OR-Funktion an einem Ausgangszweig verwirklichen, der durch eine Diode in Reihe mit einer ersten, mit Masse verbundenen resistiven Last gebildet ist, wobei jeder Schaltungsteil zwischen dem genannten ersten Pol und Masse einen Eingangszweig aufweist, der durch einen halben, aus einer zweiten resistiven Last gebildeten und mit dem ersten Pol verbundenen Eingangszweig und einem halben Eingangszweig besteht, der aus einem Transistor gebildet ist, dessen Source mit Masse, dessen Drain mit dem ersten halben Eingangszweigt und dessen Gate mit einem Eingang des Operators verbunden ist, wobei jeder Schaltungsteil ferner einen weiteren Transistor enthält, dessen Drain mit dem ersten Pol, dessen Gate mit dem Verbindungspunkt zwischen den halben Eingangszweigen und dessen Source mit dem Eingang des Ausgangszweiges verbunden ist, wobei der Ausgang (S) des Operators zwischen der Diode und der ersten resistiven Last abgegriffen ist.

9. Logischer Operator nach Anspruch 1, welcher die logische Funktion der Form NAND verwirklicht, dadurch gekennzeichnet, daß er drei Schaltungsteile umfaßt, die derart parallel geschaltet sind, daß die genannte verdrahtete OR-Funktion an einem Ausgangszweig verwirklicht wird, welcher durch eine erste, mit Masse verbundene resistive Last gebildet ist, wobei jeder Schaltungsteil in Reihe zwischen dem ersten Pol und Masse eine halbe, durch eine zweite resistive Last gebildete Eingangsschaltung und eine Eingangsschaltung umfaßt, die einen Transistor enthält, dessen Source mit Masse, dessen Drain mit dem Anschluß der zweiten, mit dem ersten Pol verbundenen resistiven Last und dessen Gate mit einem Eingang des Operators verbunden ist, wobei jeder Schaltungsteil ferner eine Diode umfaßt, die in der Richtung von dem ersten Pol nach Masse leitet und wovon ein Anschluß mit dem Drain des Transistors verbunden ist, während der andere Anschluß mit der ersten resistiven Last verbunden ist, wobei der Ausgang des Operators zwischen der Diode und der ersten resistiven Last abgegriffen ist.

**Claims**

1. Fast logic operator having a large entrance capability and operating with a single supply source a first terminal of which provides a supply voltage and the other terminal of which is connected to ground, comprising at least two field effect transistors of quasi-normally off type and having a low threshold voltage, each of these transistors comprising at least one gate connected to an input of the operator, the output signal of the operator being derived downstream from a wired OR circuit connecting the respective sources or drains of the two transistors.

2. Logic operator according to claim 1, performing the complex logic function of the form AND—OR—NAND, characterized in that it comprises two circuit portions mounted in parallel on an output branch in a manner to provide said wired OR function, each circuit portion comprising in series between said first terminal $(+V_{DD})$ and ground an input half-branch formed of a first resistive load $(CS_1)$ connected to said first terminal $(+V_{DD})$ and an input half-branch connected to ground and formed by the parallel connection of two transistors $(T'_1, T''_1)$ each having a maximum of two gates forming the inputs $(A_1, B_1, C_1, D_1)$ of the operator, each circuit portion further comprising a transistor $(T'_2)$ the gate of which is connected to the connection point of the two input half-branches, the drain of which is connected to said first terminal $(+V_{DD})$ and the source of which is connected to ground through the output branch formed by the series connection of a diode (D) connecting in the sense from the first terminal $(+V_{DD})$ towards ground and a second resistive load (CS2), the output (S) of the operator being derived between the diode (D) and the resistive load (CS2).

3. Logic operator according to claim 1, performing the complex logic function of the form AND—OR—NAND, characterized in that it comprises two circuit portions mounted in parallel on one output branch in a manner to provide said wired OR function, each circuit portion comprising in series between said first terminal $(+V_{DD})$ and ground, an input half-branch formed of a first resistive load (CS1) connected to said first terminal and an input half-branch connected to ground and formed by the parallel connection of two transistors $(T'_{11}, T''_{11})$ each comprising a maximum of two gates forming the inputs $(A_1, B_1, C_1, D_1)$ of the operator, each circuit portion further comprising a diode D', D'') conducting from the connection point of the input half-branches towards the connection point of the output branch which is formed by a second resistive load (CS2) connected to ground.

4. Logic operator according to claim 1, performing the complex logic function of the form OR—AND—NOR, characterized in that it comprises two circuit portions mounted in parallel on an output branch in a manner to provide said wired OR function, each circuit portion comprising, in series between said first terminal $(+V_{DD})$ and ground, two input branches each comprising an input half-branch formed of a resistive load (CS'2) connected to ground and an input half-branch connected to said first terminal $(+V_{DD})$ and formed by the parallel connection of two transistors (T'21, T'22) each comprising at least one gate connected to one input $(A_1, B_1)$ of the operator, the pair of these two transistors being connected in series with a diode (D') conducting in the sense from said first terminal to ground, each circuit portion further comprising a transistor (T11) having two gates respectively connected to the connection point (J', J'') between the diode and the resistive load of each input branch, the source of which is connected to ground and the drain of which is connected to the terminal of the output branch formed of a further resistive load (CS1) connected to said first terminal $(+V_{DD})$.

5. Logic operator according to claim 1, performing the complex logic function of the form OR—AND—NOR, characterized in that it comprises two circuit portions mounted in parallel on an output branch in a manner to provide said wired OR function, each circuit portion comprising, in parallel, two input branches each of which is respectively formed of the parallel connection of at least two diodes (D') conducting in the sense towards ground, the first terminal of said diodes forming an input of the operator and the other terminals of said diodes being connected to ground through a resistive load (CS'21), each circuit portion further comprising a transistor (T'1) having at least two gates, the source of which is connected to ground, each gate of which is connected to the connection point (J') of said other terminals of said diodes and said resistor in each of the respective input branches, and the drain of which is connected to the terminal of the output branch formed by another resistive load (CS1) connected to the first terminal $(+V_{DD})$ of the source.

6. Logic operator according to claim 1, performing the complex logic function of the form OR—NAND, characterized in that it comprises two circuit portions mounted in parallel in a manner to provide said wired OR function on one output branch formed of a first resistive load connected to ground, each circuit portion comprising, in series between said first terminal $(+V_{DD})$ and ground an input branch comprising, in series, an input half-branch formed by a second resistive load connected to said first terminal and an input half-branch connected to ground and formed by the parallel connection of two transistors each comprising at least one gate connected to one input (A, B) of the operator, each circuit portion further comprising a diode connecting in the sense from said first terminal towards ground, and mounted between the connection point between the input half-branches and the first resistive load, the output (S) of the operator being derived between the diode and the first resistive load.

7. Logic operator according to claim 1, performing the logic function of the form NOR, characterized in that it comprises two circuit portions mounted in parallel in a manner to provide said wired OR function on an output branch formed of a first resistive load connected to said first terminal $(+V_{DD})$, each circuit portion comprising, in series between said first terminal and ground, an input branch comprising, in series, an input half-branch formed by a second resistive load connected to ground and an input half-branch connected to said first terminal and formed by the parallel connection of two transistors each of which comprises at least one gate connected to one input (AB) of the operator, in series with a diode conducting in the sense from said first terminal towards ground, each circuit portion further comprising a transistor the source of which is connected to ground, the drain of which is connected to the first resistive load and the gate of which is connected to the connection point between the input half-branches, the output (S) of the operator being derived between the drain of the output transistor and the first resistive load.

8. Logic operator according to claim 1, performing the logic function of the form NAND, characterized in that it comprises three circuit portions mounted in parallel in a manner to provide said wired OR function on an output branch formed by a diode in series with a first resistive load connected to ground, each circuit portion comprising respectively between said first terminal and ground an input branch set up by an input half-branch formed by a second resistive load connected to said first terminal and an input half-branch formed of a transistor the source of which is connected to ground, the drain of which is connected to the first input half-branch and the gate of which is connected to an input of the operator, each circuit portion further comprising another transistor the drain of which is connected to said first terminal, the gate of which is connected to the connection point between the input half-branches and the source of which is connected to the input of the output branch, the output (S) of the operator being derived between the diode and the first resistive load.

9. Logic operator according to claim 1, performing the logic function of the form NAND, characterized in that it comprises three circuit portions mounted in parallel in a manner to provide said wired OR function on an output branch set up by a first resistive load connected to ground, each circuit portion comprising respectively, in series between said first terminal and ground, an input half-branch set up by a second resistive load, and an input half-branch comprising a transistor the source of which is connected to ground, the drain of which is connected to the terminal of said second resistive load which is connected to said first terminal, and the gate of which is an input of the operator, each circuit portion further comprising a diode connecting in the sense from said first terminal towards ground and one terminal of which is connected to the drain of the transistor, its other terminal being connected to the first resistive load, the output of the operator being derived between the diode and the first resistive load.

# FIG.1

# FIG.2

# FIG.3

# FIG.4

# FIG.5

# FIG.6

# FIG. 7

# FIG. 8

# FIG. 9

AND - OR - NAND

**FIG.10**

OR - AND - NOR

**FIG.11**

OR - AND - NOR

3

# FIG.12

OR - NAND

# FIG.13

OR - NAND

# FIG.14

NOR

4

# FIG.15

$+V_{DD}$

S

A
B

C
D

NOR

# FIG.16

$+V_{DD}$

$S = \overline{ABC}$

A

B

C

$CS_2$

NAND

# FIG.17

$+V_{DD}$

$S = \overline{ABCD}$

A

B

C

D

$CS_2$

NAND

5